# EUROPEAN PATENT SPECIFICATION

(11) **EP 1 104 647 B1**
(45) Date of publication and mention of the grant of the patent: **23.01.2013**
(21) Application number: 00918922.6
(22) Date of filing: 17.04.2000
(51) Int. Cl.: H05K 3/02, H01L 23/52, C23C 18/16

(54) **METHOD FOR MANUFACTURING SOLDERLESS HIGH DENSITY ELECTRONIC MODULES**
VERFAHREN ZUR HERSTELLUNG VON LÖTFREIEN ELEKTRONISCHEN MODULEN MIT HOHER DICHTE
PROCEDE POUR FABRIQUER DES MODULES ELETRONIQUES HAUTE DENSITE SANS SOUDURE

(30) Priority: 16.04.1999 FI 990862
(43) Date of publication of application: 06.06.2001
(73) Proprietor: Imbera Electronics Oy, 02150 Espoo (FI)
(72) Inventor: Kivilahti, Jorma, 02170 Espoo (FI); Kujala, Arni, 02340 Espoo (FI); Tuominen, Risto, 00960 Helsinki (FI)
(74) Representative: Tiilikainen, Jarkko Tapio
(86) International application number: PCT/FI2000/000327
(87) International publication number: WO 2000/067538

(56) References cited:
- EP-A2- 0 483 484
- FR-A- 2 671 417
- US-A- 5 353 195
- US-A- 5 719 749
- US-A- 5 989 653
- KUCHENMEISTER F. ET AL.: 'Film chip interconnect systems prepared by wet chemical metallization' 4TH ELECTRONIC COMPONENTS AND TECHNOLOGY CONFERENCE 25 May 1998 - 28 May 1998, SEMICON. TECHNOL. & MICROSYST. LAB., TECH. UNIV. DRESDEN, GERMANY, pages 320 - 324, XP000803633 ISBN: 0-7803-4526-6 & DATABASE INSPEC IEEE CATALOG NO. 98CH36206 Inspec No. 6068987

## Description

This invention relates to a manufacturing method of electronic devices which combines the solderless fabrication of reliable high density interconnections between active and passive components, packaging and manufacturing of structural substrate.

Continually increasing functionality of integrated circuits - especially higher signal transmission rates, lower operating voltages and smaller line widths in integrated circuits - imposes increasing demands on the physical and chemical compatibility between dissimilar materials in electrical contacts as well as on manufacturing technologies. Therefore, the reliability of the most advanced electronics is becoming one of the most important factors in limiting electrical performance. The reliability of electronics is especially important in portable products, because these high performance products with ever higher packaging densities experience - in addition to their operational stresses - various environments. Moreover, the usage of new environmental-friendly materials and processes set additional requirements to the reliability of electronics. On the other hand, shorter time-to-market cycles increase the reliability risk, because regardless of more effective R&D cycles especially new materials and manufacturing technologies demand careful evaluation and testing of products.

When producing ever higher density and higher performance electronic devices, more fundamental limitations are also being encountered the solutions to which will alter presently used materials and manufacturing techniques. For example, increasing I/O densities and smaller conductor widths of microcircuits require thinner metallizations and smaller interconnection volumes, and therefore higher current densities or interfacial chemical reactions between thin material layers, which are difficult to control, increase the failure risk of electronic products. Correspondingly, the increase in the wiring densities of printed circuit boards decreases the solder joint volumes, when the BGA and CSP components and especially Flip Chip assemblies are being used in greater extent. Hence, harmful effects of relative large fractions of brittle intermetallic compounds and impurities become stronger in the microjoints being under larger shear strains; the fact that decreases the reliability significantly.

"Flip Chip (FC)" technique, in which bare, non-encapsulated semiconductor chips are interconnected directly onto substrate, resembles BGA and CSP techniques, where interconnection bumps generally made of SnPb solder alloy are also under component. However, microcircuit is not encapsulated and the bump pitch is smaller - typically below 250 µm. Due to the smallness of bumps the accuracy of assembly machines must be very high regardless of the self alignment effect of molten solder balls. For the same reason underfill material is always used to protect the microcircuit, when the substrate material is FR4 or comparable. In addition to diminishing the stress peaks, the underfill protects the microcircuit from harmful effects of moisture and contaminations. The underfilling requires, however, additional process steps and thereby increases processing costs. Besides perfect underfilling becomes ever more difficult with smaller solder bumps and increasing bump densities. The testing and repair must be carried out before the underfilling, because after the cure of the underfill the microcircuit cannot be removed from the substrate. Flip chip assembly requires also high quality printed wiring boards.

With increased interconnection densities both bare and encapsulated semiconductor chips are getting closer to the substrate surface, which adds to shear strains and so increases the failure risk of a component board assembled with surface mount technology. The situation is also especially problematic due to low metallurgical stability of very small solder joints and large mismatch between the coefficients of thermal expansion of the substrate and silicon. Despite the underfilling the solder joints may crack during testing.

One of the most significant obstacles to the adoption of CSP packages and Flip Chip technique is the availability of low-cost and high density printed wiring boards. Presently so-called additive printed wiring board manufacturing technologies are most promising, although they are relatively expensive. However, these technologies offer significant advantages in improving the reliability of microjoints as well as in embedding passive and active components. It is expected that the line widths of integrated circuits will decrease well below 0.1 µm before the year 2010. Correspondingly, the contact areas or (I/O)'s pads on the chip will decrease below 10 µm, when the number of interconnections increases and interconnection volumes decrease strongly. In such a situation the attention will be paid to the metallurgical stability of small solder joints and to the fabrication of printed wiring boards, because the production of contact areas of 10 µm in order of magnitude sets very high requirements for the development of printed wiring board technology.

New environmental regulations and consumers' increasing awareness of environment issues drive electronics manufacturing towards lead-free and no-clean solutions. Therefore, new materials and manufacturing technologies are adopted, which may affect also the reliability of electronics. Lead is a harmful element to human beings and therefore the use of lead is banned or restricted in many applications. The electronics industry is employing lead above all in solder alloys and in protective coatings on components and printed wiring boards.

Presently there is no drop-in replacement for the eutectic tin-lead solder alloys in electronics manufacturing, although some very promising alternatives have been developed. Lead-free solders having the best mechanical properties are tin-rich alloys which have small amounts of alloying elements. Therefore their melting points are 30-50 °C higher than those of the most common tin-lead solders, that will change also the component assembly processes. Likewise, the usage of lead-free surface finishes on printed wiring boards will change the assembly processes. Along with the lead-free issue much attention is being paid to the environmental causes of fluxes and other chemicals used in soldering. Surface mount technology being based on so-called no-clean soldering is very much alike to conventional surface mount technology except for the cleaning of flux residues. The development of no-clean processes is also driven by the expectations of lower production costs. The removal of the cleaning process from the production line reduces equipment, chemical, labor and waste disposal costs. This is, however, possible only if the no-clean assembly process can be executed reliably.

Hence, the need to enhance concurrently the reliability, performance and economy of electronics manufacturing drives the integration of manufacturing technologies. Similarly, continuously decreasing size and increasing number of passive components on the printed wiring board drives to integrate the components into the substrate. Especially manufacturers of consumer electronics are interested in integration of passive components into the substrate. In this way more space is left for other discrete components. In addition to the increased packaging density, i.e. larger silicon-to-substrate ration, the manufacturing process is simplified. But also active components can be embedded into printed wiring boards.

Integration of microcircuits into printed wiring board with so-called "chip first"-technique is one of the methods to solve the problems related to interconnecting high density microcircuits. In this method a microcircuit is connected to the substrate before the wiring and electrical contacts are formed.

The patent FR 2 671 417 discloses a method for manufacturing a package of active components, embedded into a substrate and leaving their contact pads exposed. Interconnections are provided by using conductive ink.

The patents US 5353195, US 5353498, US 5422513 and US 5497033 present solutions to problems related to high density component interconnections.

In the methods presented in these patents the microcircuits are attached to ceramic or polymeric substrates. When microcircuits are integrated into the ceramic substrate, cavities being slightly larger than the microcircuits are formed so that the top surfaces of the microcircuits are on the same level with the ceramic substrate. The cavities can be formed by mechanical or laser drilling or by casting the substrate into a mould. Microcircuits are attached to the cavities with an adhesive from the backside of the circuits, after which the gap between the microcircuits and the substrate is cast with a ceramic or polymer material. After this a polyimide film is laminated onto the substrate surface and the vias to the microcircuits are formed through the polyimide film by laser drilling. The wiring is produced with the semiadditive technique, in which the surface of the substrate is sputtered with a metal or alloy, and this is followed by the electrochemical plating of the conductors. Because of the nonplanarity of the substrate surface the exposure of the photoimageable resist is made with laser. When microcircuits are integrated into polymeric substrate, the microcircuits are aligned onto a thin polymer film. This is followed by casting of the microcircuits into the epoxy by using a casting mould. The properties of the epoxy are improved by filling the polymer with glass or ceramic particles, mostly with silica particles. The epoxy must have good mechanical durability, low shrinkage, similar CTE with silicon, and it must be compatible also with other materials used. After casting the component is detached from the mold and the vias are formed through the thin polymer film with the laser drilling. The wiring structure on the component surface is also produced with the semiadditive technique.

According to the above-mentioned patents the manufacturing of electrical contacts to the microcircuits and the wiring on the substrate requires the field metallisation which is produced by sputtering before the electrolytic plating. The sputtering technique demands the use of vacuum, which makes the process time-consuming, expensive and restricts the size of the substrate. Moreover, the perfect coverage of the complicated surfaces is difficult and in some applications it requires the use of elevated temperatures. In mass production the repeated use of vacuum decreases the throughput of the process. The size of the vacuum chamber restricts the size and number of the substrates to be sputtered simultaneously. The semiadditive method requires the coating of several thin metal layers (for example, adhesion layers). Consequently, there are several interfaces between dissimilar metallisations which present potential reliability risk In the semiadditive manufacturing of the wiring structure the excess panel plating is etched away. The etching process sets limitations to the minimum line width which can be fabricated. It also produces toxic wastes.

Document XP-0008036333, "Film Chip Interconnect Systems Prepared by Wet Chemical Metallization" by Küchenmeister et al. discloses microelectronics packaging using electroless copper deposition and laser micromachining techniques.

The principal objective of the present invention related to manufacturing reliable high density electronics is to provide a new technique and method without the drawbacks of the techniques and methods of the known art. The interconnections and microjoints manufactured by using the technique and method of the present invention are electrically, mechanically and chemically superior to those produced with the techniques of the known art. Passive components that are connected to active components can be fabricated by using the technique of the present invention.

In the following the embodiments of the present invention and its benefits in comparison to the fabrication techniques of the previous art are described.

The fully additive fabrication technique of the present invention is simpler to execute, it is more cost-effective and it can be used to eliminate the disadvantages related to the techniques of the known art. With the technique and method of the present invention a package of one active component or integrated functional modules with one or several active and passive components can be fabricated. Microcircuits of various thickness can be embedded into a single module board so that the active surface of the components are at the same level with the substrate. Copper, is used as a pad metallisation for the embedded microcircuits. When copper (I/O) pads on integrated circuits are used copper-to-copper interconnections can be fabricated with the invented fully additive active component embedding and interconnection technique. In such a case the interconnections are made solely of copper.

More specifically the present invention concerns a method defined in claim 1.

Several advantages are achieved with the fully additive active component embedding technique as compared the techniques of the known art. The fully additive active component embedding technique does not require metal etching at any process step. The interconnections are fabricated at ambient temperatures using wet-chemical, electroless deposition process. The composition of the electroless baths can be refreshed during the deposition process, thus enabling a long service life and producing only a small amount of bath residuals. The fully additive embedding technique of microcircuits includes only a few process steps. Therefore, the technique is reliable, cost-effective and simple to use. Both single large area components and several small area components can be interconnected simultaneously with the technique. Copper conductors and copper-to-copper electrical contacts can be fabricated with the invented technique. Consequently, there is the perfect metallurgical compatibility between contact metals and therefore the problems related to small interconnections produced with the techniques of the known art can be eliminated. The fabrication process does not require vacuum or high processing temperatures during the fabrication of the interconnections. As a matter of fact, the technique and method of the present invention combines the three presently separate manufacturing processes: substrate or PWB manufacturing, active component packaging and the fabrication of the interconnections into one simple, reliable and cost-effective fabrication process. Because the electrical interconnections are fabricated using chemical deposition, soldering is not needed. This gives significant benefits when manufacturing reliable electrically functional high density interconnections .

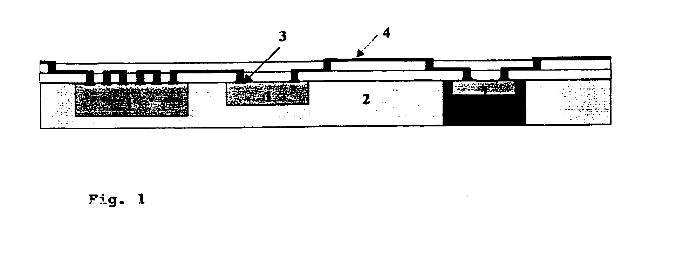

Figure 1 shows schematically an integrated module board fabricated with the technique of the present invention This example presents the cross-section of a "printed wiring board" or module board containing three interconnection levels. The active components (1) are embedded into the substrate (2) so that the opening of the active components (3) are visible. The conductors for the active components openings (4) are fabricated using the fully additive build-up technique of the present invention.

In the following a simple example of integrated module boards which can be fabricated with the invented fully additive component embedding and interconnection technique is presented:

### Phase 1

The microcircuits or active components (1) are embedded into a substrate (2) so that the open (I/O) pads of the components (3) are visible, while the rest of the active components are molded inside polymer substrate.

### Phase 2

The flat surface of polymer is normally roughened prior to the activation step. Depending on the properties of the polymer the roughening can be made by employing chemical, mechanical, electrical or thermal treatments. The surface is roughened for achieving adequate adhesion of the deposited metal to the polymer. The roughened substrate surface and the openings or (I/O) pads of microcircuits are activated. The activation is carried out with a catalyst. Typically colloidal tin-palladium solution is used as a catalyst for the electroless copper solution. Palladium is the catalyst for the oxidation/reduction reaction and the tin protects the palladium from the oxidation. The activated surface is electrically non-conductive.

### Phase 3

The conductor structure is defined by using a permanent photodefinable polymer dielectric in the photolithographic process. Typically the photolithographic process is divided into the four processing steps: coating, exposure, development and the curing. During the exposure step the properties of the photodefinable polymer are modified so that the polymer can be dissolved selectively. During the development step the activated surface (2) is uncovered under the photodefinable polymer for the electroless copper deposition in the phase 4.

### Phase 4

Electroless copper is deposited on the uncovered areas of the substrate and on the I/O's of the microcircuit. After the complex chemical reactions the copper ions are deposited onto the activated surface. The copper deposition process is autocatalytic (or self-catalytic).

Electroless copper deposition is slower than that of the electrochemical copper. The deposition rates for electroless copper are typically 2-3 µm per hour, which makes it easy to control the deposited copper thickness. The deposition rate can be adjusted with the deposition temperature, which is typically somewhat higher than room temperature. The conductivity of the copper can be increased with the increasing thickness.

The above-described fabrication steps or phases 2-4 are repeated several times for fabricating a desired multilayer structure with all the electrical interconnections.

In addition to the above-described fabrication process, all its variations where alternative chemicals are used for fabricating integrated multilayer module boards belong to the scope of the present invention, defined in the appended claims.

## Claims

1. A method for manufacturing a package of one active component or an integrated functional module with one or several active and passive components, wherein in a first stage, at least one active component (1) is embedded in a substrate (2) so that contact pads (3) of the component (1) are exposed, **characterized in that**
in the following stages the at least one component (1) is electrically interconnected
by providing conductor patterns using photolithographic processing of a permanent photodefinable polymer dielectric coating and
building up copper conductor structures and interconnections using wet-chemical electroless deposition process, wherein the at least one active component (1) comprises copper contact pads, so that
the interconnections are copper-to-copper interconnections.

2. A method according to claim 1, wherein the conductor structures and interconnections are fabricated at ambient temperature and at atmospheric pressure.

3. A method according to claim 1 or 2, wherein the at least one active component (1) is a bumpless component.

## Patentansprüche

1. Verfahren zur Herstellung einer Baugruppe aus einem aktiven Bauelement oder einem integrierten Funktionsmodul mit einem oder mehreren aktiven und passiven Bauelement(en), wobei in einem ersten Schritt mindestens ein aktives Bauelement (1) in ein Substrat (2) eingebettet wird, so dass Kontaktinseln (3) des Bauelements (1) frei liegen, **dadurch gekennzeichnet, dass**
in den folgenden Schritten das mindestens eine Bauelement (1) elektrisch verschaltet wird,
indem durch fotolithographische Bearbeitung einer permanenten dielektrischen Beschichtung aus fotodefinierbarem Polymer Leitermuster erzeugt werden und
durch ein nasschemisches stromloses Abscheidungsverfahren Kupferleiterstrukturen und -verbindungen aufgebaut werden, wobei das mindestens eine aktive Bauelement (1) Kupferkontaktinseln umfasst, so dass
die Verbindungen Kupfer-Kupfer-Verbindungen sind.

2. Verfahren nach Anspruch 1, wobei die Leiterstrukturen und - verbindungen bei Umgebungstemperatur und atmosphärischem Druck gefertigt werden.

3. Verfahren nach Anspruch 1 oder 2, wobei das mindestens eine aktive Bauelement (1) ein bondinselfreies Bauelement ist.

## Revendications

1. Procédé de fabrication d'un paquet formé d'un composant actif ou d'un module fonctionnel intégré avec un ou plusieurs composants actifs et passifs, dans lequel, dans un premier stade, au moins un composant actif (1) est noyé dans un substrat (2) de sorte que les patins de contact (3) du composant (1) soient exposés, **caractérisé en ce que** :
dans les étapes suivantes, le au moins un composant (1) est interconnecté électriquement
en fournissant des motifs conducteurs utilisant un traitement photolithographique d'un revêtement diélectrique de polymère photodéfinissable permanent, et
en élaborant des structures conductrices de cuivre et des interconnexions utilisant un processus de dépôt electroless de produits chimiques à l'état humide, dans lequel le au moins un composant actif (1) comprend des patins de contact en cuivre de sorte que les interconnexions soient des interconnexions de cuivre-cuivre.

2. Procédé selon la revendication 1, dans lequel les structures et les interconnexions de conducteurs sont fabriquées à température ambiante et à pression atmosphérique.

3. Procédé selon la revendication 1 ou la revendication 2, dans lequel le au moins un composant actif (1) est un composant sans à-coups.
